**Europäisches Patentamt**

**European Patent Office**

**Office européen des brevets**

(19)

(11) Veröffentlichungsnummer : **0 032 599**
**B1**

(12) **EUROPÄISCHE PATENTSCHRIFT**

(45) Veröffentlichungstag der Patentschrift :
01.10.86

(21) Anmeldenummer : 80201160.1

(22) Anmeldetag : 05.12.80

(51) Int. Cl.⁴ : **H 01 L 29/743**

(54) Thyristor zum verlustarmen Schalten kurzer Impulse.

(30) Priorität : 16.01.80 CH 342/80

(43) Veröffentlichungstag der Anmeldung :
29.07.81 Patentblatt 81/30

(45) Bekanntmachung des Hinweises auf die Patenterteilung : 01.10.86 Patentblatt 86/40

(84) Benannte Vertragsstaaten :
CH DE GB LI

(56) Entgegenhaltungen :
DE-A- 1 935 164
DE-A- 2 802 843
US-A- 4 054 893
IEEE TRANSACTIONS ON ELECTRON DEVICES, Band ED-23, Nr. 8, August 1976, Seiten 883-887, New York, USA, J. SHIMIZU et al.: "High-voltage high-power gate-assisted turn-off thyristor for high-frequency use"
IEEE TRANSACTIONS ON ELECTRON DEVICES, Band ED-23, Nr. 8, August 1976, Seiten 888-892, New York, USA, E.S. SCHLEGEL: "Gate-assisted turnoff thyristors"

(73) Patentinhaber : BBC Aktiengesellschaft Brown, Boveri & Cie.
Haselstrasse
CH-5401 Baden (CH)

(72) Erfinder : Jaecklin, André A., Dr. Ing. ETH
Geissbergstrasse 55
CH-5400 Ennetbaden (CH)

**Beschreibung**

Die vorliegende Erfindung betrifft einen Thyristor zum verlustarmen Schalten kurzer Impulse, mit einem integrierten Hilfsthyristor zum Verbessern des zeitlichen Stromanstiegs beim Einschalten und einer antiparallel geschalteten integrierten Diode zum Verkürzen der Freiwerdezeit beim durch das Gate unterstützen Abschalten.

Eine der wesentlichen Aufgaben bei der Weiterentwicklung von Thyristoren ist das Verbessern der Schalteigenschaften. Eine gebräuchliche Massnahme zum Verbessern der Steilheit des Stromanstiegs beim Einschalten ist das Einbauen eines Hilfsthyristors oder amplifying gate zwischen dem als Gate verwendeten Teil der p-Basis und der benachbarten Umrandung der Kathoden-Emitterschicht. Eine andere bekannte Massnahme zum Verkürzen der Freiwerdezeit beim Abschalten ist das Anlegen einer negativen Spannung an das Gate während des Abschaltintervalls, was vom Fachmann als gate assisted turn-off (GATT) bezeichnet wird.

Die beiden Massnahmen sind nicht unabhängig voneinander, sondern der zwischen dem Gate und dem Kathoden-Emitter angeordnete Hilfsthyristor behindert beim Abschalten die Wirkung der negativen Spannung am Gate auf den Kathoden-Emitter. Um diesen Nachteil zu überwinden, ist es bekannt, eine integrierte Diode zu verwenden, die antiparallel zum Hilfsthyristor geschaltet ist und diesen kurzschliesst, wenn eine negative Spannung an das Gate gelegt wird. Entsprechende Untersuchungen sind von J. Shimzu et al in IEEE Transactions on Electron Devices, Vol. ED-23, Aug. 76, S. 883 ff beschrieben, worauf hier ausdrücklich hingewiesen wird. Wie die Praxis gezeigt hat, weist auch diese Massnahme Mängel auf. Die Diode enthält eine $n^+$-Schicht, die beim Anlegen der negativen Spannung an das Gate Elektronen in die p-Basis injiziert. Diese Elektronen können eine unkontrollierte Zündung und gegebenenfalls sogar die Zerstörung des Thyristors bewirken, wenn sie in ausreichender Menge in die nach dem Löschen des Thyristors von der wiederansteigenden Blockierspannung induzierte Raumladungszone gelangen. Um diesen Mangel zu beheben, sind Versuche unternommen worden, den Abstand des $n^+$-p-Uebergangs der Diode von der Raumladungszone des Thyristors zu vergrössern, was praktisch bedeutet, dass die $n^+$-Schicht der Diode weniger tief in die p-Zone eindiffundiert wird als die $n^+$-Schichten der Emitter des Thyristors und des Hilfsthyristors. Die dafür erforderliche Technologie ist sehr aufwendig, und die Praxis hat gezeigt, dass auch bei solcherart konzipierten Thyristoren die unkontrollierte Zündung während des gate assisted turn-off nur dann vermieden werden kann, wenn der negative Impuls am Gate auf die Eigenschaften des Thyristors und dessen Betriebsbedingungen abgestimmt ist.

Der vorliegenden Erfindung liegt darum die Aufgabe zugrunde, einen Thyristor mit integriertem Hilfsthyristor und ebenfalls integrierter, antiparallel geschalteter Diode zu schaffen, bei dem die Herstellung der integrierten Diode keine aufwendigen Arbeitsgänge erfordert und bei dem die unkontrollierte Zündung während des Anlegens der Negativspannung an das Gate praktisch behoben ist.

Erfindungsgemäss wird dieses Aufgabe mit einem Thyristor gelöst, der dadurch gekennzeichnet ist, dass die integrierte Diode als Schottky-Kontakt ausgebildet ist.

Der neue Thyristor hat den Vorteil, dass der als Diode wirkende Schottky-Kontakt bei normalen Betriebsbedingungen nur Majoritätsträger und keine Elektronen in die p-Zone injiziert. Wenn bei ungewöhnlichen Betriebsbedingungen ausser diesen Majoritätsträgern auch wenige Elektronen injiziert werden, dann können diese praktisch keine unkontrollierte Zündung bewirken, weil deren Zahl gering ist und die Lebensdauer dieser Elektronen und damit auch ihre Diffusionslänge im Bereich der Thyristoroberfläche klein ist und weil der an der kathoden-emitter-seitigen Oberfläche angeordnete Schottky-Kontakt einen maximalen Abstand von der durch die wiederansteigende Blockierspannung induzierten Raumladungszone aufweist.

Bei einer bevorzugten Ausführungsform des neuen Thyristors weist die $n^+$-Schicht des Hilfsthyristors mindestens eine sektorförmige Aussparung auf, in der der Schottky-Kontakt angeordnet ist.

Im folgenden wird ein bevorzugtes Ausführungsbeispiel des neuen Thyristors mit Hilfe der Figuren beschrieben. Es zeigen :

Figur 1 die Draufsicht auf den mittleren Teil der kathoden-emitter-seitigen Oberfläche einer besonders einfachen Ausführungsform des neuen Thyristors vor dem Aufbringen der Metallisierung,

Figur 2 den Schnitt längs der Linie A-A durch den Thyristor gemäss der Fig. 1 nach dem Aufbringen der Metallisierung und

Figur 3a und 3b grafische Darstellungen des zeitlichen Verlaufs des Stroms am Gate sowie der Spannung und des Stroms zwischen Kathoden- und Anodenanschluss des Thyristors.

In den Figuren sind die p-leitenden Zonen oder Bereiche mit einer von links unten nach rechts oben verlaufenden Schraffierung, die n-leitenden Zonen oder Bereiche mit einer von links oben nach rechts unten verlaufenden Schraffierung versehen. Höher dotierte Zonen oder Bereiche weisen eine dichtere Schraffierung als niedriger dotierte auf. Weiter sind in den Figuren gleiche Teile mit gleichen Bezugszeichen versehen.

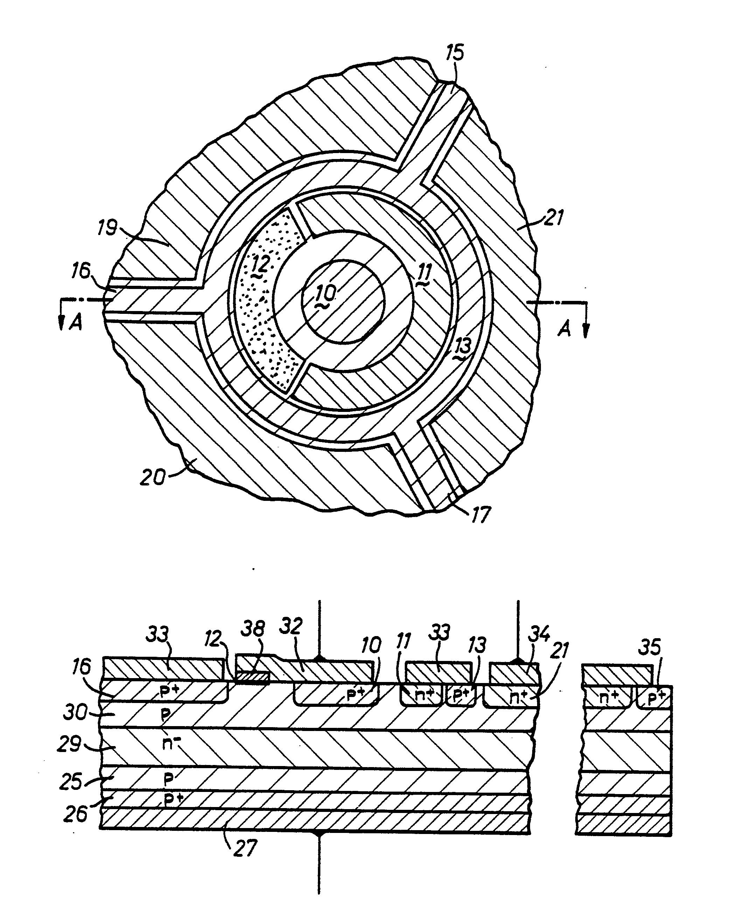

Die Fig. 1 zeigt die Draufsicht auf den mittleren Teil einer einfachen Ausführungsform des neuen Thyristors, dessen unterschiedliche Bereiche und Zonen kreisbogenförmige Begrenzungen aufweisen und konzentrisch zueinander angeordnet sind. Der deutlicheren Darstellung wegen sind in dieser Figur die zur Kontaktierung verwendeten Metallisierungen nicht gezeigt. In der Mitte der Thyristorteiloberfläche ist ein Kreisscheibenförmiges, p$^+$-dotiertes Gate 10 angeordnet. Um das Gate liegt ein ringsektorförmiger, n$^+$-dotierter Bereich 11 des Hilfsthyristors. Der zum ringsektorförmigen Bereich 11 komplementäre, zur p-Basis gehörende Bereich 12 ist als Grenzfläche für den Schottky-Kontakt vorgesehen. Die beiden einander ergänzenden ringsektorförmigen Bereiche 11, 12 sind von einer ringförmigen, p$^+$-dotierten sekundären Steuerelektrode 13 des Hilfsthyristors eingeschlossen. Zur sekundären Steuerelektrode gehören drei um 120° versetzte, in radialer Richtung nach aussen weisende Verzweigungen 15, 16, 17. Um die sekundäre Steuerelektrode und zwischen deren Verzweigungen ist die in drei Sektoren 19, 20, 21 unterteilte, n$^+$-dotierte Kathoden-Emitterzone angeordnet.

Die Fig. 2 zeigt den Schnitt längs der Linie A-A durch den Thyristor gemäss der Fig. 1. Danach enthält der Thyristor eine Anodenzone 25 mit einer p$^+$-dotierten Schicht 26, die an der Anodenmetallisierung 27 anliegt, sowie eine mittlere Zone mit einer n$^-$-dotierten Basis 29 und einer p-dotierten Basis 30. In die p-dotierte Basis 30 sind das bereits erwähnte Gate 10, der zum Hilfsthyristor gehörende Bereich 11, die sekundäre Steuerelektrode 13 mit ihren Verzweigungen, von denen im Schnitt nur die Verzweigung 16 zu sehen ist, sowie die Sektoren der Emitter-Kathode, von denen nur der Sektor 21 zu sehen ist, eindiffundiert. Weiter zeigt Fig. 2 die Metallisierung 32 des Gate 10, die Metallisierung 33 des Hilfsthyristors und seiner Verzweigung 16 sowie die Kathoden-Emittermetallisierung 34. Emitterkurzschlüsse 35 verbinden die p-dotierte Basis direkt mit der Kathoden-Emittermetallisierung 34.

Fig. 2 zeigt weiter den Bereich 12 der p-dotierten Basis 30, der als Grenzfläche für den Schottky-Kontakt vorgesehen ist, sowie die daran anliegende Metallschicht 38 des Schottky-Kontakts. Diese Metallschicht ist über die Metallisierung 32 metallisch leitend mit dem Gate 10 verbunden.

Verfahren zur Herstellung des beispielsweise beschriebenen Thyristors mit integriertem Hilfsthyristor sind jedem Fachmann bekannt und beispielsweise von A. Blicher in « Thyristor Physics », Springer N.Y. 1976, pp. 119-130 beschrieben, worauf hier ausdrücklich hingewiesen wird. Zur Herstellung des Schottky-Kontakts genügt es, wenn auf einen Oberflächenbereich der p-dotierten Basis eine dünne Schicht aus einem geeigneten Metall oder einer Legierung aufgebracht wird. Damit der Schottky-Kontakt eine ausreichend hohe Sperrspannung aufweist, sollte die Oberflächenkonzentration der p-dotierten Basis kleiner sein als $5 \cdot 10^{17}$ cm$^{-3}$ und vorzugsweise kleiner als $5 \cdot 10^{16}$ cm$^{-3}$. Für den Schottky-Kontakt gut geeignete Metalle sind beispielsweise Aluminium, Gold, Molybdän oder Wolfram, die vorzugsweise aufgedampft werden. Es ist aber auch möglich, anstelle eines Metalls eine Legierung zu verwenden, wobei unter Legierung alle aus mindestens zwei Komponenten bestehende Systeme verstanden werden, die eine stöchiometrische oder auch nicht stöchiometrische Zusammensetzung aufweisen und mindestens ein Metall und/oder Metalloid, wie beispielsweise Silizium, enthalten. Eine bevorzugte Legierung dieser Art ist PtSi. PtSi-Schichten haben den Vorteil, dass sie gleichzeitig mit dem Abbrennen der Maske oder zusammen mit den anderen Metallisierungen getempert werden können.

Bei der Verwendung des neuen Thyristors erscheint der positive Steuerimpuls für das Gate auch an der Metall- oder Legierungsschicht des Schottky-Kontakts. Die Sperrspannung dieses Kontakts muss darum grösser sein als die Spannung des maximal zulässigen Steuerimpulses. Sobald eine negative Spannung an das Gate geleitet wird, injiziert die Schottky-Diode einen Strom, der durch die p-dotierte Basis unter dem Kathoden-Emitter zu den Emitterkurzschlüssen fliesst, die vom Gate und Hilfsthyristor beabstandet im Bereich des äusseren seitlichen Randes des Thyristors angeordnet sind. Das von diesem Strom erzeugte Potential ist dann ausreichend, um zu verhindern, dass beim raschen Ansteigen der Blockierspannung an der Anode der n$^+$-dotierte Kathoden-Emitter Elektronen injiziert.

Es versteht sich, dass viele Modifikationen des beschriebenen Ausführungsbeispiels des neuen Thyristors möglich sind. Beispielsweise kann der Schottky-Kontakt auch an der n-dotierten Basis angeordnet werden, wenn diese ausreichend niederohmig ist, um die beim Anlegen der negativen Spannung injizierten Elektronen rasch an die Emitterkurzschlüsse abzuleiten. Es ist auch möglich, über der relativ dünnen Metall- oder Legierungsschicht der Schottky-Diode eine zusätzliche Metallschicht aufzutragen, was insbesondere vorteilhaft ist, wenn die Querleitfähigkeit der erstgenannten Schicht relativ schlecht ist. Weiter ist es möglich, um den Rand des Schottky-Kontakts eine zusätzliche n-Diffusionszone oder einen Schutzring, z. B. aus Poly-Si, anzubringen, insbesondere wenn die Sperrspannung des Kontakts erhöht oder der Leckstrom verkleinert werden soll. Solche Schutzringe sind in IBM Techn. Discl. Bull. 21 (1978) 2752 beschrieben, worauf hier ausdrücklich hingewiesen wird.

Es versteht sich auch, dass anstelle der in den Figuren gezeigten einfachen geometrischen Anordnung, insbesondere des Hilfsthyristors, und die entsprechende Unterteilung des Kathoden-Emitters wesentlich kompliziertere Anordnungen bzw. Unterteilungen verwendet werden können.

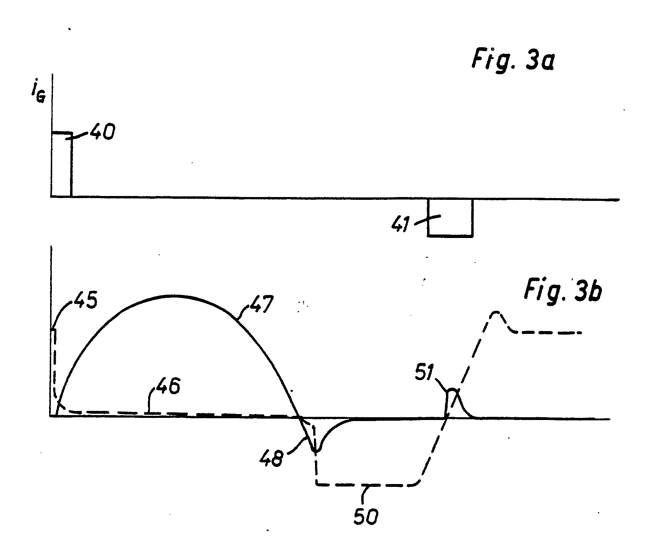

In den Fig. 3a und 3b ist der typische zeitliche Verlauf der Spannung am Gate und der damit verbundenen integrierten Diode bzw. der Spannung zwischen der Kathoden- und der Anodenmetallisierung und des Stroms durch den Thyristor aufgezeichnet. Für die gezeigten Kurven ist angenommen, dass ein Kondensator aus einer Gleichspannungsquelle geladen und durch eine mit einem Thyristor in Serie geschaltete Induktivität entladen wird. Die Kurven zeigen, dass kurz nach dem Einleiten des Zündstroms 40 in das Gate die Spannung 45 am Thyristor auf dessen Durchlasspannung 46 absinkt und der Stromfluss 47 einsetzt. Wie jedem Fachmann geläufig ist, ist der zeitliche Verlauf des Stroms von der Ladespannung und der Kapazität des Kondensators sowie der Grösse der Induktivität und des Widerstands im Entladekreis abhängig. Im gewählten Beispiel wird der Strom beim Erreichen des Wertes Null nicht unterbrochen, sondern es folgt ein kurzer Stromstoss 48 in umgekehrter Richtung, bevor der Strom praktisch auf den Wert Null absinkt, während eine Spannung 50 mit umgekehrtem Vorzeichen am Thyristor anliegt. Die Steilheit der zeitlichen Stromänderung im Bereich der Richtungsumkehr beträgt typischerweise 10 Ampère/μsec. Mit dem Wiederaufladen des Kondensators wird die negative Spannung am Thyristor ab- und die ursprüngliche positive Spannung wieder aufgebaut. Wenn die Zeitspanne zwischen dem Unterbrechen des Stroms durch den Thyristor und dem Wiederanstieg der Spannung in der Grössenordnung der Freiwerdezeit des Thyristors liegt, dann bewirken die noch vorhandenen freien Ladungsträger beim Nulldurchgang der Spannung einen Stromstoss 51. Dabei versteht sich wiederum, dass die Grösse dieses Stromstosses von der Stromstärke während der vorgängigen Zündung, vom zeitlichen Abstand zwischen dem Verlöschen und dem Spannungsanstieg und natürlich von den spezifischen Eigenschaften des Thyristors abhängig ist. Um zu verhindern, dass dieser Stromstoss eine ungewollte Zündung des Transistors einleitet, wird vor dem Nulldurchgang der Ladespannung und dem dadurch bewirkten Einsetzen dieses Stromstosses ein negativer Impuls 41 an das Gate und die damit verbundene integrierte Diode gelegt.

Wie bereits weiter oben ausführlich beschrieben wurde, werden bei der erfindungsgemässen Ausbildung der integrierten Diode als Schottky-Kontakt während der Dauer dieses negativen Impulses keine Elektronen in die p-Basis des Thyristors injiziert, d. h. es werden die noch vorhandenen restlichen Ladungsträger nicht durch injizierte Elektronen vermehrt, weshalb der Schwellwert für eine ungewollte Zündung des Thyristors beim Wiederansteigen der Spannung ganz wesentlich erhöht wird.

Bezeichnungsliste

10 = Gate
11 = $n^+$-Schicht
12 = Oberflächenbereich
13 = Steuerelektrode
15-17 = Verzweigungen
19-21 = Sektoren
25 = Anodenzone
26 = $p^+$-Schicht
27 = Anodenmetallisierung
29 = $n^-$-Basis
30 = p-Basis
32, 33 = Metallisierung
34 = Kathoden-Emittermetallisierung
35 = Emitterkurzschlüsse
38 = Metallschicht
40 = Zündstrom
41 = negativer Impuls
45 = Spannung
46 = Durchlassspannung
47 = Stromfluss
48 = Stromstoss
50 = Spannung
51 = Stromstoss

**Patentansprüche**

1. Thyristor zum verlustarmen Schalten kurzer Impulse, mit einem integrierten Hilfsthyristor zum Verbessern des zeitlichen Stromanstiegs beim Einschalten und einer antiparallel geschaltenen, integrierten Diode zum Verkürzen der Freiwerdezeit beim durch das Gate unterstützten Abschalten, dadurch gekennzeichnet, dass die integrierte Diode als Schottky-Kontakt (12, 38) ausgebildet ist.

2. Thyristor nach Anspruch 1, dadurch gekennzeichnet, dass der Schottky-Kontakt aus einem mit einem Metall (38) oder einer Legierung beschichteten Oberflächenbereich (12) der p-Basis (30) gebildet ist.

3. Thyristor nach Anspruch 1, dadurch gekennzeichnet, dass der Schottky-Kontakt (12, 38) in der lateral strukturierten p-Basis (30) zwischen dem Gate (10) und dem Kathoden-Emitter (19, 20) angeordnet ist.

4. Thyristor nach Anspruch 2, dadurch gekennzeichnet, dass das Metall (38) des Schottky-Kontakts Aluminium, Gold, Molybdän oder Wolfram ist.

5. Thyristor nach Anspruch 2, dadurch gekennzeichnet, dass die Legierung des Schottky-Kontakts PtSi ist.

6. Thyristor nach Anspruch 2, dadurch gekennzeichnet, dass das Metall oder die Legierung des Schottky-Kontakts (38) mit einer Schicht hoher elektrischer Leitfähigkeit abgedeckt ist.

7. Thyristor nach Anspruch 2, dadurch gekennzeichnet, dass im Bereich des Schottky-Kontakts (12, 38) die Oberflächenkonzentration in der p-Basis (30) kleiner als $5 \cdot 10^{17}/cm^3$ und vorzugsweise kleiner als $5 \cdot 10^{16}/cm^3$ ist.

8. Thyristor nach Anspruch 1, dadurch gekennzeichnet, dass die Randzone des Schottky-Kontakts (12, 38) zum Verringern des Leckstroms eine zusätzliche n-Zone oder einen Schutzring aus Poly-Silizium aufweist.

9. Thyristor nach Anspruch 1, bei dem der Kathoden-Emitter (19, 20, 21) symmetrisch um den als Gate (10) ausgebildeten Teil der p-Zone (30) angeordnet ist und zwischen dem Umfang des Gate und dem inneren Rand des Kathoden-Emitters die $n^+$- und $p^+$-Schicht (11 bzw. 13) des Hilfsthyristors angeordnet ist, dadurch gekennzeichnet, dass die $n^+$-Schicht des Hilfsthyristors mindestens eine sektorförmige Aussparung aufweist, in der der Schottky-Kontakt (12, 38) angeordnet ist.

10. Thyristor nach Anspruch 7, dadurch gekennzeichnet, dass die Kathoden-Emitterschicht in radialsymmetrisch zum Gate (10) angeordnete Sektoren (19, 20, 21) unterteilt ist und die als sekundäre Steuerelektrode verwendete p+-Schicht (13) des Hilfsthyristors in radialer Richtung verlaufende Verzweigungen (15, 16, 17), aufweist, welche zwischen den radialen Rändern der Emittersektoren angeordnet sind.

## Claims

1. Thyristor for the low-loss switching of short pulses, having an integrated auxiliary thyristor for the improvement of the temporal current rise on switching-on and an antiparallel-connected, integrated diode to reduce the recovery time on switching-off assisted by the gate, characterized in that the integrated diode is constructed as a Schottky contact (12, 38).

2. Thyristor according to Claim 1, characterized in that the Schottky contact is formed from a surface region (12) — coated with a metal (38) or an alloy — of the p-base (30).

3. Thyristor according to Claim 1, characterized in that the Schottky contact (12, 38) is disposed in the laterally structured p-base (30) between the gate (10) and the cathode emitter (19, 20).

4. Thyristor according to Claim 2, characterized in that the metal (38) of the Schottky contact is aluminium, gold, molybdenum or tungsten.

5. Thyristor according to Claim 2, characterized in that the alloy of the Schottky contact is PtSi.

6. Thyristor according to Claim 2, characterized in that the metal or the alloy of the Schottky contact (38) is covered with a layer of high electrical conductivity.

7. Thyristor according to Claim 2, characterized in that in the region of the Schottky contact (12, 38) the surface concentration in the p-base (30) is less than $5 \cdot 10^{17}/cm^3$, and preferably less than $5 \cdot 10^{16}/cm^3$.

8. Thyristor according to Claim 1, characterized in that in order to reduce the leakage current the edge zone of the Schottky contact (12, 38) has an additional n-zone or a protective ring of polysilicon.

9. Thyristor according to Claim 1, wherein the cathode emitter (19, 20, 21) is disposed symmetrically about the part — constructed as gate (10) — of the p-zone (30), and the n+- layer and p+- layer (11 and 13 respectively) of the auxiliary thyristor are disposed between the periphery of the gate and the inner edge of the cathode emitter, characterized in that the n+- layer of the auxiliary thyristor exhibits at least a sector-shaped recess, in which the Schottky contact (12, 38) is disposed.

10. Thyristor according to Claim 7, characterized in that the cathode emitter layer is subdivided into sectors (19, 20, 21) disposed radially symmetrically with respect to the gate (10), and the p+- layer (13) of the auxiliary thyristor, which layer is employed as secondary control electrode, exhibits branches (15, 16, 17), which extend in the radial direction and which are disposed between the radial edges of the emitter sectors.

## Revendications

1. Thyristor pour la commutation à faible perte d'impulsions courtes, comportant un thyristor auxiliaire intégré pour améliorer la montée du courant dans le temps lors de la mise en circuit et une diode intégrée connectée en antiparallèle pour raccourcir le temps de recouvrement lors de la mise hors circuit soutenue par la gâchette, caractérisé en ce que la diode intégrée a la forme d'un contact de Schottky (12, 38).

2. Thyristor suivant la revendication 1, caractérisé en ce que le contact de Schottky est formé d'une zone superficielle (12) de la base p (30) recouverte d'un métal (38) ou d'un alliage.

3. Thyristor suivant la revendication 1, caractérisé en ce que le contact de Schottky (12, 38) dans la base p à structure latérale (30) est disposée entre la gâchette (10) et l'émetteur de cathode (19, 20).

4. Thyristor suivant la revendication 2, caractérisé en ce que le métal (38) du contact de Schottky est de l'aluminium, de l'or, du molybdène ou du tungstène.

5. Thyristor suivant la revendication 2, caractérisé en ce que l'alliage du contact de Schottky est du PtSi.

6. Thyristor suivant la revendication 2, caractérisé en ce que le métal ou l'alliage du contact de Schottky (38) est couvert au moyen d'une couche de conductivité électrique supérieure.

7. Thyristor suivant la revendication 2, caractérisé en ce que dans la zone du contact de Schottky (12, 38), la concentration superficielle dans la base p (30) est inférieure à $5 \cdot 10^{17}/cm^3$ et de préférence inférieure à $5 \cdot 10^{16}/cm^3$.

8. Thyristor suivant la revendication 1, caractérisé en ce que la zone marginale du contact de Schottky (12, 38) présente une zone n supplémentaire ou un anneau de garde en polysilicium pour réduire le courant de fuite.

9. Thyristor suivant la revendication 1, dans lequel l'émetteur de cathode (19, 20, 21) est disposé symétriquement autour de la partie de la zone p (30) formant la gâchette (10) et entre le pourtour de la gâchette (10) et le bord intérieur de l'émetteur de cathode est disposée la couche n+ et p+ (11 ou 13) du transistor auxiliaire, caractérisé en ce que la couche n+ du transistor auxiliaire présente au moins un évidement en forme de secteur dans lequel le contact de Schottky (12, 38) est disposé.

10. Thyristor suivant la revendication 7, caractérisé en ce que la couche d'émetteur de cathode est subdivisée en secteurs (19, 20, 21) qui sont radialement symétriques par rapport à la gâchette (10) et la couche p+ (13) utilisée comme électrode de commande secondaire du transistor auxiliaire présente des branchements (15, 16, 17) qui s'étendent radialement et qui sont disposés entre les bords radiaux des secteurs d'émetteur.

$i_G$

40

41

*Fig. 3a*

45

47

46

48

50

51

*Fig. 3b*